# EUROPEAN PATENT SPECIFICATION

(11) **EP 4 756 568 B1**
(45) Date of publication and mention of the grant of the patent: **21.10.2026**
(21) Application number: 25193725.6
(22) Date of filing: 04.08.2025
(51) Int. Cl.: G06F 1/187, G11B 33/12, H05K 7/14, G06K 19/077

(54) **TRAY FOR SOLID STATE DRIVE AND DRIVE SERVER DEVICE INCLUDING THE SAME**
ABLAGE FÜR FESTKÖRPERLAUFWERK UND LAUFWERKSERVERVORRICHTUNG DAMIT
PLATEAU POUR DISQUE À SEMI-CONDUCTEURS ET DISPOSITIF DE SERVEUR DE DISQUE COMPRENANT CELUI-CI

(30) Priority: 05.12.2024 KR 20240179094
(43) Date of publication of application: 10.06.2026
(73) Proprietor: Samsung Electronics Co., Ltd., Suwon-si, Gyeonggi-do 16677 (KR)
(72) Inventor: SHIN, Seohyun, 16677 Suwon-si, Gyeonggi-do (KR); LEE, Kitaek, 16677 Suwon-si, Gyeonggi-do (KR); LEE, Seunghan, 16677 Suwon-si, Gyeonggi-do (KR); SON, Jungmoo, 16677 Suwon-si, Gyeonggi-do (KR)
(74) Representative: Kuhnen & Wacker Patent- und Rechtsanwaltsbüro PartG mbB

(56) References cited:
- WO-A1-2021/015871
- US-A1- 2008 003 883
- US-A1- 2016 183 374
- US-A1- 2019 246 508

## Description

### BACKGROUND

The present disclosure relates to a tray for a solid state drive and a drive server device including the same, and more particularly, to a server tray of a solid state drive suitable for heat dissipation and solid state drives of various form factors and a drive server device including the same.

Solid state drives (SSDs) store information using a semiconductor device method and have a faster read/write speed and generate less heat and noise than hard disk drives (HDDs). In addition, solid state drives do not require mechanical operation and are resistant to external shocks.

In addition, solid state drives have less power consumption, decreased weight, and an extended lifespan, and thus, demand therefor as information storage mediums has increased.

When a solid state drive product is provided in a drive sub-device, a tray equipped with a solid state drive (hereinafter referred to as a drive tray) may be covered with a cover case and then coupled to the drive sub-device.

A fastening structure for coupling the cover case to the drive tray not only requires time for fastening, but also has the problem of difficulty in integration due to the size thereof.

In addition, due to the structure covering the cover case, if at least 30 to 40 solid state drives are fastened to the drive sub-device, there is a problem of heat dissipation.

In addition, the drive tray may not be suitable for different solid state drive standards.

US 2019/246508 A1 discloses a solid state drive device and its associated housing.

### SUMMARY

One or more example embodiments provide a solid state drive tray capable of increasing the integration of solid state drives in a drive server device by applying a guide frame structure without a cover case.

One or more example embodiments provide a solid state drive tray with high heat dissipation efficiency by applying a heat dissipation structure that may respond to heat generation between a solid state drive and a guide frame.

One or more example embodiments provide a solid state drive tray having a convenient function capable of accommodating solid state drives having different sizes (form factors).

One or more example embodiments provide a drive server device to which a plurality of high-integration solid state drive trays are applied.

According to an aspect of an example embodiment, a solid state drive tray includes: a solid state drive substrate including a printed circuit board (PCB) and a semiconductor chip mounted on the PCB; a guide frame including an upper frame contacting an upper portion of the PCB, a side frame provided with a sliding rail into which a side portion of the PCB is inserted and slidably fastened, and a lower frame defining a connector passage portion; a hinge joint portion including a hinge connecting the side frame and one side of the lower frame and a joint portion fixing the side frame and the lower frame at the other side of one side in which the hinge is disposed; and a connector portion extending from one side of the PCB and externally exposed through the connector passage portion while the side frame and the lower frame are fixed by the hinge joint portion.

According to another aspect of an example embodiment, a solid state drive tray includes: a solid state drive including: a PCB in which metal interconnections and insulators are repeatedly stacked; a semiconductor chip on the PCB; and a connector portion extending from one side of a lower portion of the PCB; a guide frame including: an upper frame contacting an upper portion of the PCB; a side frame including a sliding rail into which a side portion of the PCB is inserted and slidably fastened; and a lower frame connected to the side frame opposite the upper frame, wherein the lower frame defines a connector passage to accommodate the connector portion; a telescopic rail portion movably coupling the upper frame and the side frame; and a hinge joint portion including a hinge connecting the side frame and a first side of the lower frame and a joint portion fixing the side frame and a second side of the lower frame. The connector portion is exposed through the connector passage while the side frame and the lower frame are fixed by the hinge joint portion.

According to another aspect of an example embodiment, a drive server device includes: a plurality of solid state drive trays; and a server body configured to accommodate the plurality of solid state drive trays. A solid state drive tray of the plurality of solid state drive trays includes: a solid state drive substrate including: a PCB in which metal interconnections and insulators are repeatedly stacked; a semiconductor chip on the PCB; and a connector portion extending from one side of a lower portion of the PCB; a guide frame including: an upper frame contacting an upper portion of the PCB; a side frame including a sliding rail into which a side portion of the PCB is inserted and slidably fastened; and a lower frame connected to the side frame opposite the upper frame, wherein the lower frame defines a connector passage to accommodate the connector portion; a telescopic rail portion movably coupling the upper frame and the side frame; and a hinge joint portion including a hinge connecting the side frame and a first side of the lower frame and a joint portion fixing the side frame and a second side of the lower frame. The connector portion is exposed through the connector passage while the side frame and the lower frame are fixed by the hinge joint portion.

### BRIEF DESCRIPTION OF DRAWINGS

The above and other aspects, features, and advantages will be more apparent from the following description of example embodiments, taken in conjunction with the accompanying drawings, in which:
FIG. 1 is a schematic perspective view of a solid state drive tray according to an example embodiment;
FIG. 2 is a schematic perspective view of a guide frame of a drive tray according to an example embodiment;
FIG. 3 is a schematic perspective view of a solid state drive being slidably inserted into a guide frame according to an example embodiment;
FIG. 4 is a schematic perspective view of a solid state drive completely inserted into a guide frame according to an example embodiment;
FIG. 5 is a schematic perspective view of a lower frame of a guide frame being closed according to an example embodiment;
FIG. 6 is a schematic perspective view of a guide frame of a drive tray according to another example embodiment;
FIG. 7 is a schematic perspective view of an upper guide frame of a guide frame of a drive tray being extended according to another example embodiment;
FIG. 8 is a schematic enlarged view illustrating a portion of an upper guide frame according to an example embodiment;
FIG. 9 is a cross-sectional view of a lower frame of a guide frame according to an example embodiment;
FIG. 10 is a cross-sectional view of a lower frame of a guide frame according to an example embodiment; and
FIG. 11 is a schematic perspective view of a drive server device according to an embodiment.

### DETAILED DESCRIPTION

Hereinafter, example embodiments will be described with reference to the accompanying drawings.

The examples may be modified into other forms and are provided so that this disclosure will be thorough and complete. In the drawings, the shapes and dimensions of elements may be exaggerated for clarity, and like reference numerals denote like elements. Elements indicated by identical or similar reference numerals on the drawings indicate identical or similar elements.

In will be further understood that when an element is referred to as being "connected to," "coupled to" or "joined to" another element, it may be directly connected or joined to the other element, or intervening elements may be present, or each element may be "connected to," "coupled to" or "joined to" each other through another element. By contrast, when an element is referred to as being "directly connected to," "directly coupled to" or "directly joined to" another element or layer, there are no intervening elements or layers present.

As used herein, the terms "1st" or "first" and "2nd" or "second" may use corresponding components regardless of importance or order and are used to distinguish a component from another component without limiting the components.

The terms used herein are used to describe examples and are not intended to limit the present inventive concept. A singular term includes a plural form unless otherwise indicated.

### Solid State Drive Tray

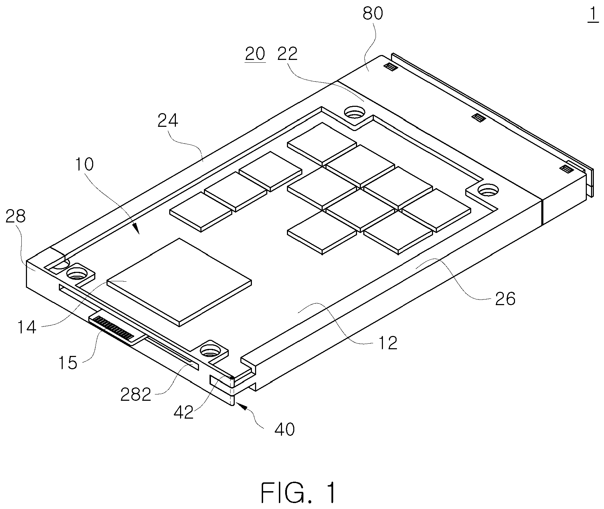

FIG. 1 is a schematic perspective view of a solid state drive tray according to an example embodiment.

Referring to FIG. 1, a solid state drive tray 1 (hereinafter referred to as 'drive tray') according to an example embodiment includes a solid state drive substrate 10, a guide frame 20, and a hinge joint portion 40.

The solid state drive substrate 10 may include a printed circuit board (PCB) 12 and a semiconductor chip 14 mounted on the printed circuit board 12.

A plurality of semiconductor chips 14 may be mounted on the PCB 12. The plurality of semiconductor chips 14 may be used to provide a solid state drive function.

For example, the plurality of semiconductor chips 14 may include a NAND flash memory, a dynamic random-access memory (DRAM), a control device controlling a function of a memory, and the like.

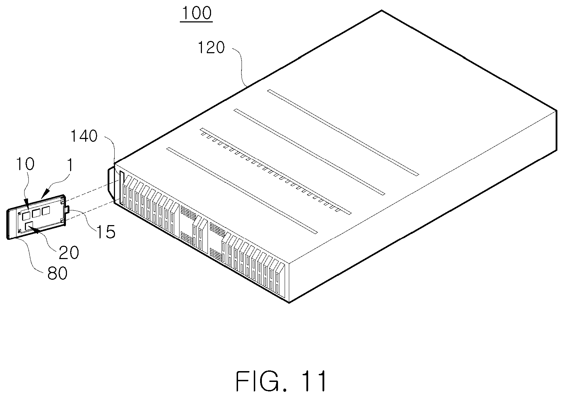

The solid state drive substrate 10 may be accommodated in the guide frame 20 to be applied to a drive server device 100 (see FIG. 11).

The guide frame 20 has a shape that may accommodate the solid state drive substrate 10 of a rectangular form factor, such as E3.S, E3.L, E3.S 2T, E3.L 2T, etc.

Here, the width (W) × length (L) × thickness (W) specifications of E3.S, E3.L, E3.S 2T, and E3.L 2T are 76 mm × 112.75 mm × 7.5 mm, 76 mm × 142.2 mm × 7.5 mm, 76 mm × 112.75 mm × 16.8 mm, and 76 mm × 142.2 mm × 16.8 mm, respectively.

The guide frame 20 is configured in a rectangular shape and includes an upper frame 22, side frames 24 and 26, and a lower frame 28. The guide frame 20 may be configured to accommodate a solid state drive substrate having dimensions of, for example, 76 mm × 112.75 mm × 7.5 mm, 76 mm × 142.2 mm × 7.5 mm, 76 mm × 112.75 mm × 16.8 mm, and 76 mm × 142.2 mm × 16.8 mm.

The upper frame 22 is in contact with an upper portion of the PCB 12. An upper surface portion of the PCB 12 may be fastened to a groove formed in upper frame 22, to be coupled thereto.

The side frames 24 and 26 may be provided with sliding rails 245 and 265 into which a side portion of the PCB 12 is inserted and slidably fastened.

In addition, the lower frame 28 may be in contact with a lower portion of the PCB 12. The lower frame 28 may be provided with, or may define, a connector passage portion 282. The solid state drive board 10 (e.g. solid state drive substrate 10) may include a connector portion 15 extending from one side of the lower portion of the PCB 12. The connector portion 15 includes an electrical terminal connected to a drive sub-device 100 (e.g. drive server device 100).

The lower frame 28 may be hinge-connected to the side frames 24 and 26.

In addition, the hinge joint portion 40 may include a hinge portion 42 and joint portions 44 and 46.

The hinge portion 42 of FIG. 1 may connect one side of the side frame 26 and one side of the lower frame 28, and one end of the lower frame 28 in which the hinge portion 42 is not disposed may rotate around the hinge portion 42 so as to be connected to the corresponding side frame 24.

The joint portions 44 and 46 of FIG. 1 may be a hook portion 44 provided on the lower frame 28 and a hook catch portion 46 on the side frame 24. The hook portion 44 and the hook catch portion 46 are only examples, and joint portions 44 and 46 that are hinge-coupled or snap-coupled, may also be implemented.

The connector passage portion 282 may be formed in the lower frame 28 to allow the connector portion 15 to pass therethrough and be exposed to the outside of the lower frame 28 when the side frames 24 and 26 and the lower frame 28 are fixed by the hinge joint portion 40.

The connector passage portion 282 of an example embodiment is disclosed as a hole structure surrounded by a partition wall in the lower frame 28, but example embodiments are not particularly limited as long as it is a structure through which the connector portion 15 extending from one side of a lower portion of the PCB 12 passes and is exposed to the outside of the lower frame 28.

In addition, the drive tray 1 of FIG. 1 further includes a latch portion 80 on the upper frame 22 opposite the connector portion 15.

The latch portion 80 is a device that may grip and lock the connector portion 15 of the drive tray 1 to move the connector portion 15 so as to be inserted into an accommodating slot (140, FIG. 11) of the drive server device 100.

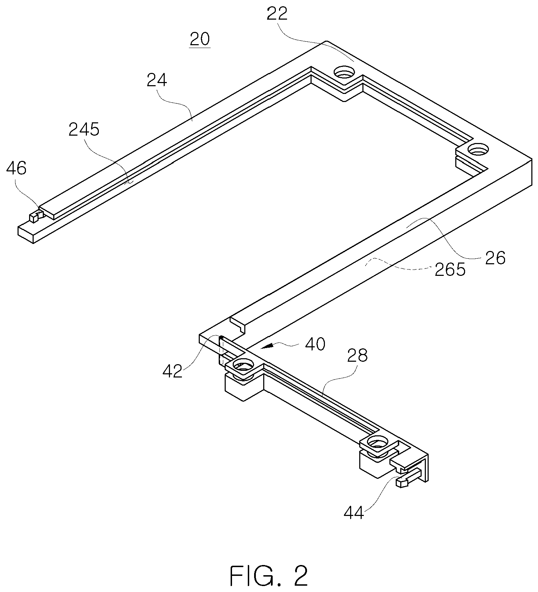

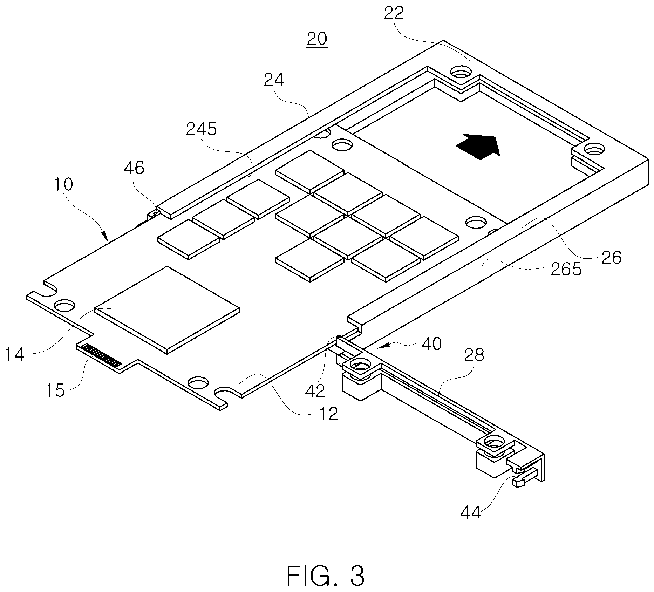

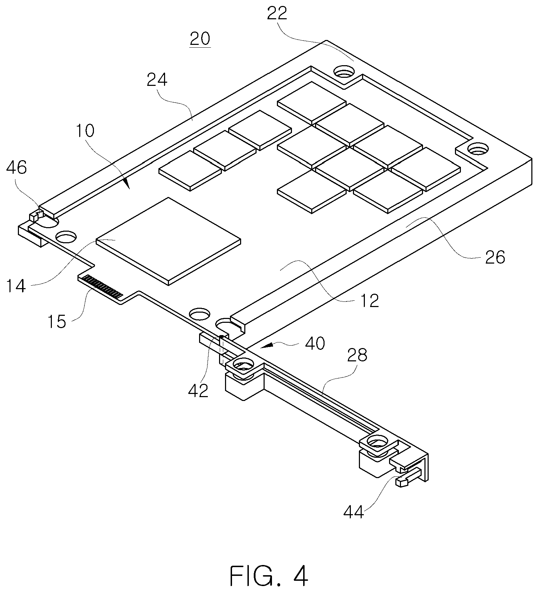

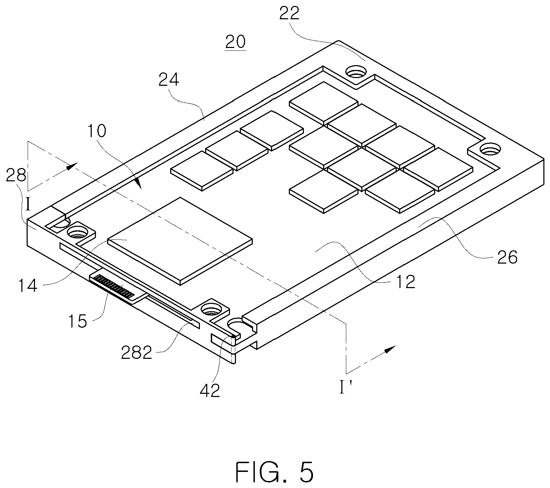

FIG. 2 is a schematic perspective view of a guide frame of a drive tray according to an example embodiment, FIG. 3 is a schematic perspective view of a solid state drive being slidably inserted into the guide frame of FIG. 2, FIG. 4 is a schematic perspective view of a solid state drive being completely slidably inserted into the guide frame of FIG. 2, and FIG. 5 is a schematic perspective view of a lower frame of the guide frame of FIG. 2 being closed.

A configuration in which the solid state drive substrate 10 is mounted on the guide frame 20 is described with reference to FIGS. 2 to 5.

FIG. 2 is a view illustrating a state in which a hinge portion 42 is opened in the guide frame 20 of a drive tray 1 according to an example embodiment. For example, the hinge portion 42 may be opened to prepare for mounting the solid state drive substrate 10.

FIG. 3 illustrates a state in which a side portion of the solid state drive substrate 10 is inserted into sliding rails 245 and 265 provided on both side frames 24 and 26 of the guide frame 20 in a sliding manner according to an example embodiment.

The sliding rails 245 and 265 on both side frames 24 and 26 may have a '⊏' shape so that the side portion of the solid state drive substrate 10 may be inserted.

As illustrated in FIG. 4, the side portions of the solid state drive substrate 10 are slidably moved along the sliding rails 245 and 265 of both side frames 24 and 26 so that the upper portion of the solid state drive substrate 10 comes into contact with the upper frame 22.

Referring to FIG. 5, after the upper portion of the solid state drive substrate 10 is completely in contact with the upper frame 22 of the guide frame 20, the lower frame 28 may be closed to the side frames 24 and 26.

One end of the lower frame 28 in which the hinge portion 42 is not disposed rotates around the hinge portion 42 so as to be connected to the corresponding side frame 24.

At this time, the connector portion 15 extending from one side of the lower portion of the PCB 12 is extends through the connector passage portion 282 of the lower frame 28 and is exposed externally.

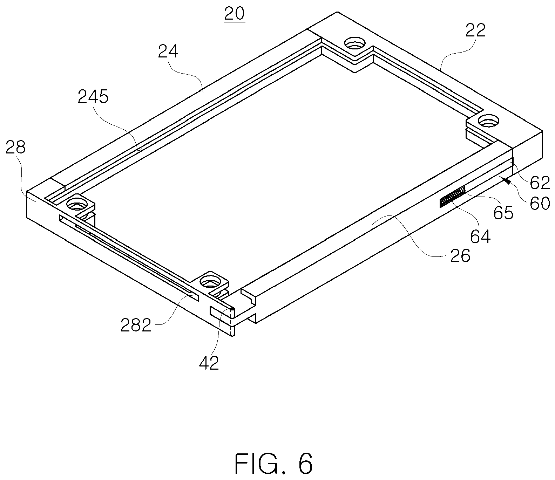

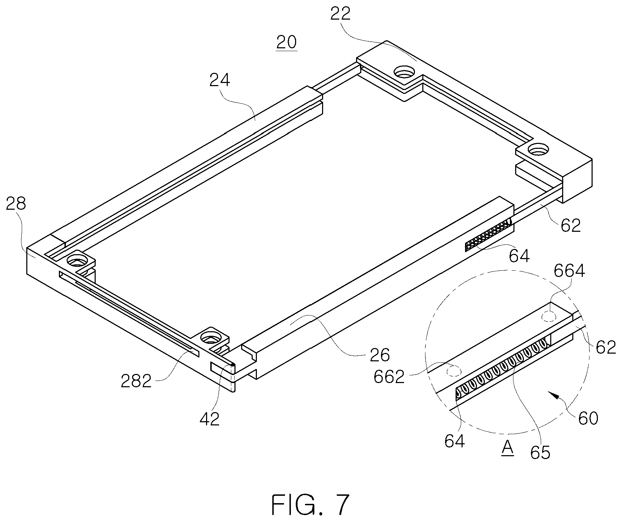

FIG. 6 is a schematic perspective view of a guide frame of a drive tray according to another example embodiment, and FIG. 7 is a schematic perspective view of an upper guide frame of a guide frame of a drive tray being extended according to another example embodiment

Referring to FIGS. 6 and 7, the guide frame 20 of the drive tray 1 according to another example embodiment is disclosed.

The guide frame 20 includes a telescopic rail portion 60 coupling the upper frame 22 and the side frames 24 and 26. Because the other components are the same as those of the drive tray 1 of FIG. 1, a detailed description thereof will be omitted.

The telescopic rail portion 60 is configured so that the upper frame 22 may be drawn into or out of the side frames 24 and 26, so that a length may increase.

For example, the drive tray 1 may accommodate the solid state drive substrate 10 of the E3. S and E3.L form factors.

As described above, in the case of the E3.S form factor in which width (W) × length (L) × thickness (W) specifications are 76 mm × 112.75 mm × 7.5 mm, the telescopic rail portion 60 may be configured so that the upper frame 22 is fully inserted into the side frames 24 and 26.

In addition, in the case of the E3.L form factor in which width (W) × length (L) × thickness (W) specifications are 76 mm × 142.2 mm × 7.5 mm, the telescopic rail portion 60 may be configured so that the upper frame 22 is drawn out from the side frames 24 and 26.

The telescopic rail portion 60 of FIGS. 6 and 7 includes a slide slot 64, an elastic member 65, and a guide rod portion 62.

The slide slot 64 is formed in a groove shape on outer side walls of the side frames 24 and 26. The length of the slide slot 64 is formed to be slightly longer than a difference in length L between E3.S and E3.L, for example.

The elastic member 65 is disposed inside the slide slot 64, and the guide rod portion 62 extends from both sides of the upper frame 22 to the slide slot 64 and may be drawn out from the slide slot 64 by the elastic member 65.

Position determining portions 662 and 664 for securing the position of the guide rod portion 62 may be arranged in the slide slot 64. The position determining portions 662 and 664 may include a recess and a protrusion arranged in the slide slot 64 and the guide rod portion 62, which may secure the upper frame 22 at draw-in and drawn-out positions of the guide rod portion 62 in the slide slot 64.

A distance between a first position determining portion 662 and a second position determining portion 664 of FIG. 7 may correspond to the difference in length L between E3.S and E3.L. When the guide rod portion 62 is drawn into the slide slot 64 and fixed at the first position determining portion 662, a short-length E3.S form factor solid-state drive substrate 10 may be accommodated. At this time, the elastic member 65 stores elasticity.

When the guide rod portion 62 is drawn out of the slide slot 64 by the elasticity of the elastic member 65 and fixed at the second position determining portion 664, a long-length E3.L form factor solid-state drive substrate 10 may be accommodated.

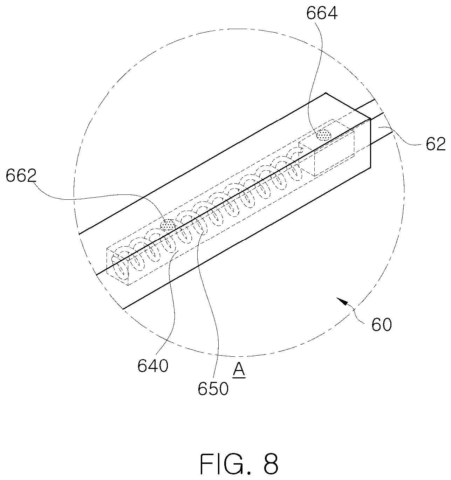

FIG. 8 is a schematic enlarged view illustrating another example embodiment of portion A of FIG. 7.

In contrast to the slide slot 64 of FIGS. 6 and 7, the telescopic rail portion 60 has a well-shaped sliding channel 640 formed on both sides of the side frames 24 and 26.

The telescopic rail portion 60 of FIG. 8 includes a slide channel 640, an elastic member 650, and a guide rod portion 62.

The slide channel 640 is formed in a groove shape on the upper surfaces of the side frames 24 and 26. A length of the slide channel 640 is formed to be slightly longer than the difference in length L between E3.S and E3.L, for example.

The elastic member 650 is disposed in the slide channel 640, and the guide rod portion 62 may extend from both sides of the upper frame 22 to the slide channel 640. The guide rod portion 62 may be drawn out from the slide channel 640 by the elastic member 650.

The position determining portions 662 and 664 may be arranged in the slide channel 640. The position determining portions 662 and 664 may include a recess and a protrusion arranged in the slide channel 640 and the guide rod portion 62, similar to FIGS. 6 and 7 and may secure drawn-in and drawn-out positions of the guide rod portion 62 in the slide slot 64.

A distance between the first position determining portion 662 and the second position determining portion 664 of FIG. 8 may also correspond to the difference in length L between E3.S and E3.L. When the guide rod portion 62 is drawn into the slide channel 640 and fixed in the first position determining portion 662, a short-length E3.S form factor solid-state drive substrate 10 may be accommodated. At this time, the elastic member 65 stores elastic force.

When the guide rod portion 62 is drawn out of the slide channel 640 by elastic force of the elastic member 650 and fixed in the second position determining portion 664, a long-length E3.L form factor solid-state drive substrate 10 may be accommodated.

Hereinafter, a heat dissipation structure of the solid state drive tray 1 will be described in detail.

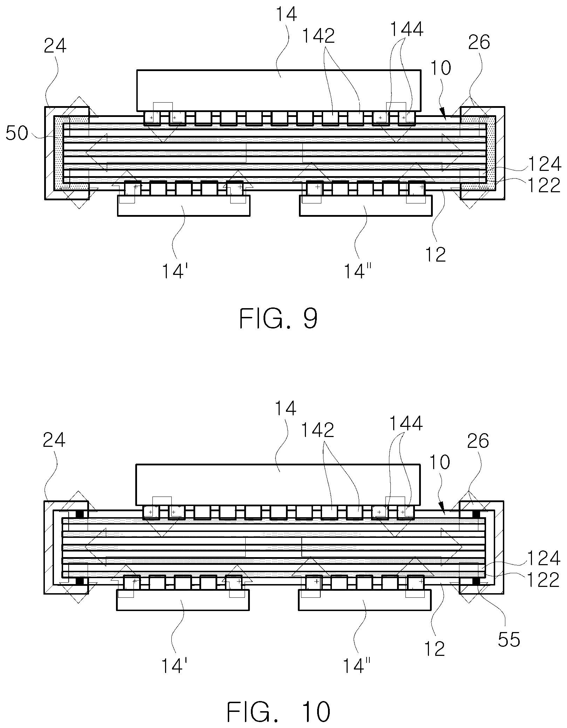

FIG. 9 is a cross-sectional view of a first example embodiment according to I-I' of FIG. 5.

Referring to FIG. 9, a heat dissipation structure of an example embodiment in the solid state drive tray 1 is illustrated.

First, the PCB 12 of the solid state drive substrate 10 is formed by repeatedly stacking metal interconnections 122 and insulators 124.

A plurality of semiconductor chips 14 are mounted on the PCB 12, and the semiconductor chips may include, for example, DRAM 14', NAND flash memory 14," and control devices controlling the functions of the memory.

The semiconductor chips 14 are equipped with solder balls 142 and 144 and mounted on the PCB 12.

The solder balls 142 and 144 include a solder ball 142 and a dummy solder ball 144. The solder ball 142 may be actually connected to the metal interconnection 122, and in this regard may be used for controlling or driving the semiconductor chips 14. The dummy solder ball 144 may be or may not be connected to the metal interconnection 122, and may not be related to the driving of the semiconductor chip 14.

In FIG. 9, the dummy solder ball 144 is also connected to the metal interconnection 122 of the PCB 12.

The metal interconnection 122 of the PCB 12 is configured to have a high content of copper (Cu) of 70% or more, and thus, the metal interconnection 122 may be referred to as a copper layer and has very high thermal conductivity. The insulator 124 insulates the metal interconnection 122 from the outside as a solder mask coating.

On a side surface of the PCB 12 inserted into the sliding rails 245 and 265 of the side frames 24 and 26, the metal interconnection 122 may be partially exposed through the insulator 124. For example, the solder mask coating layer, may be peeled off to expose the metal interconnection 122.

In this manner, when the metal interconnection 122 is exposed from the side surface of the PCB 12 inserted into the sliding rails 245 and 265 of the side frames 24 and 26, heat from the semiconductor chip 14 may be conducted to the side frames 24 and 26 through the metal interconnection 122, and thus, the conductivity is very high.

In addition, the shape of the metal interconnection 122 may be changed when designing the PCB 12. If there is no portion not contacting the sliding rails 245 and 265 of the side frames 24 and 26, the metal interconnection 122 may be added.

The arrows illustrated in FIG. 9 indicate that heat of the semiconductor chips 14, 14', and 14" is discharged through the solder balls 142 and 144 including the dummy solder ball 144, the metal interconnection 122, and the side frames 24 and 26.

In addition, thermal grease 50 may be applied to the side frames 24 and 26 and the metal interconnection 122 exposed on the side surface of the PCB 12 inserted into the sliding rails 245 and 265 of the side frames 24 and 26.

The thermal grease facilitates the mounting and movement of the PCB 12 within the sliding rails 245 and 265, increases the thermal conductivity of the metal interconnection 122 of the PCB 12, and facilitates heat transfer to the side frames 24 and 26.

FIG. 10 is a cross-sectional view of a second example embodiment according to I-I' of FIG. 5.

Referring to FIG. 10, a heat dissipation structure of an example embodiment is illustrated in the solid state drive tray 1.

The structure of the PCB 12 or semiconductor chip 14 of the heat dissipation structure of FIG. 10 is substantially the same as the heat dissipation structure of FIG. 9, described above.

The PCB 12 of the solid state drive substrate 10 is formed by repeatedly stacking the metal interconnections 122 and the insulators 124.

A plurality of semiconductor chips 14 are mounted on the PCB 12, and the semiconductor chips may include, for example, DRAM 14', NAND flash memory 14," and control devices controlling the functions of the memory.

The semiconductor chips 14 are equipped with solder balls 142 and 144 and mounted on the PCB 12.

The solder balls 142 and 144 include a solder ball 142 and a dummy solder ball 144. The solder ball 142 may be actually connected to the metal interconnection 122, and in this regard may be used for controlling or driving the semiconductor chips 14. The dummy solder ball 144 may be or may not be connected to the metal interconnection 122, and may not be related to the driving of the semiconductor chip 14.

In FIG. 10, the dummy solder ball 144 is also connected to the metal interconnection 122 of the PCB 12.

The metal interconnection 122 of the PCB 12 is configured to have a high content of copper (Cu) of 70% or more, and thus, the metal interconnection 122 may be referred to as a copper layer and has very high thermal conductivity. The insulator 124 insulates the metal interconnection 122 from the outside as a solder mask coating.

On a side surface of the PCB 12 inserted into the sliding rails 245 and 265 of the side frames 24 and 26, the metal interconnection 122 may be partially exposed through the insulator 124. For example, the solder mask coating layer, may be peeled off to expose the metal interconnection 122.

In this manner, when the metal interconnection 122 is exposed from the side surface of the PCB 12 inserted into the sliding rails 245 and 265 of the side frames 24 and 26, heat from the semiconductor chip 14 may be conducted to the side frames 24 and 26 through the metal interconnection 122, and thus, the conductivity is very high.

In addition, the shape of the metal interconnection 122 may be changed when designing the PCB 12. If there is no portion not contacting the sliding rails 245 and 265 of the side frames 24 and 26, the metal interconnection 122 may be added.

The arrows illustrated in FIG. 10 indicate that heat of the semiconductor chips 14, 14', and 14" is discharged through the solder balls 142 and 144 including the dummy solder ball 144, the metal interconnection 122, and the side frames 24 and 26.

Here, solder having a high thermal conductivity compared to thermal grease is dotted on the metal interconnection 122 exposed on the side surface of the PCB 12 inserted into the sliding rails 245 and 265 of the side frames 24 and 26.

A material of a solder dotting 55 may be, for example, at least one of Ni, Au, and a mixture thereof having a high conductivity.

In addition, thermal grease may be applied to the PCB 12 and the side frames 24 and 26.

The thermal grease facilitates the mounting and movement of the PCB 12 within the sliding rails 245 and 265, increases the thermal conductivity of the metal interconnection 122 of the PCB 12, and facilitates heat transfer to the side frames 24 and 26.

### Drive Server Device

FIG. 11 is a schematic perspective view of a drive server device according to an example embodiment.

The drive server device 100 includes a plurality of solid state drives, so that the storage capacity unit may be expanded to petabytes, rather than gigabytes or terabytes.

As described above, the guide frame 20 structure covering upper and lower surfaces of the solid state drive tray 1 may maximize the integration of the solid state drive.

The drive server device 100 according to an example embodiment includes a plurality of solid state drive trays 1 and a server body 120.

The plurality of solid state drive trays 1 may be inserted and connected to the accommodating slots 140 formed in the drive server body 120.

The accommodating slot 140 is provided with a connector accommodating portion to which the connector portion 15 exposed from the solid state drive tray 1 may be connected to provide current or signals.

Each example embodiment may be applied to the solid state drive tray 1, and in addition, all example embodiments may be combined and applied thereto within a range that is not contradictory.

According to the solid state drive tray and the drive server device according to an example embodiment, because the guide frame structure without a curved case is adopted, the time for case fastening may be saved.

In addition, because the size of the drive tray inserted into the drive sub-device is reduced due to the case removal, the integration efficiency of the sub-device may be improved.

In addition, the heat dissipation effect may be improved by the heat dissipation structure even when a large number of solid state drives are fastened to the drive sub-device.

In addition, at least a portion of the guide frame (20) of the drive tray may be extended, so that solid state drives of various form factors may be fixed to one drive tray.

## Claims

1. A solid state drive tray (1) comprising:
a solid state drive substrate (10) comprising a printed circuit board, PCB (12), and a semiconductor chip (14) mounted on the PCB (12);
a guide frame (20) comprising an upper frame (22) contacting an upper portion of the PCB (12), a side frame (24, 26) provided with a sliding rail (245, 265) into which a side portion of the PCB (12) is inserted and slidably fastened, and a lower frame (28) defining a connector passage portion (282);
a hinge joint portion (40) comprising a hinge portion (42) connecting the side frame (24, 26) and one side of the lower frame (28) and a joint portion (44, 46) fixing the side frame (24, 26) and the lower frame (28) at the other side of one side in which the hinge portion (42) is disposed; and
a connector portion (15) extending from one side of the PCB (12) and externally exposed through the connector passage portion (282) while the side frame (24, 26) and the lower frame (28) are fixed by the hinge joint portion (40).

2. The solid state drive tray (1) of claim 1, wherein the upper frame (22) is configured to be drawn out from the side frame (24, 26), and
wherein the solid state drive tray (1) further comprises:
a slide slot (64) formed in the side frame (24, 26);
an elastic member (65, 650) in the slide slot (64); and
a guide rod portion (62) extending from both sides of the upper frame (22) to the slide slot (64) and connected to the elastic member (65, 650).

3. The solid state drive tray (1) of claim 1, wherein the upper frame (22) is configured to be drawn out from the side frame (24, 26), and
wherein the solid state drive tray (1) further comprises:
a slide channel (640) formed within the side frame (24, 26) connected to the upper frame (22);
an elastic member (65, 650) in the slide channel (640); and
a guide rod portion (62) extending from both sides of the upper frame (22) to the slide channel (640) and connected to the elastic member (65, 650).

4. The solid state drive tray (1) of claim 3, further comprising a position determining portion (662, 664) configured to secure a position of the guide rod portion (62), wherein the position determining portion (662, 664) is provided in the slide channel (640).

5. The solid state drive tray (1) of any one of claims 1 to 4, further comprising thermal grease (50),
wherein a metal interconnection (122) is exposed from the side portion of the PCB (12) inserted into the sliding rail (245, 265) of the side frame (24, 26), and the thermal grease (50) is provided between the metal interconnection (122) and the sliding rail (245, 265).

6. The solid state drive tray (1) of any one of claims 1 to 5, further comprising solder,
wherein a metal interconnection (122) is exposed from the side portion of the PCB (12) inserted into the sliding rail (245, 265) of the side frame (24, 26), and the solder is provided between the metal interconnection (122) and the sliding rail (245, 265).

7. A solid state drive tray (1) comprising:
a solid state drive substrate (10) comprising:
a printed circuit board, PCB (12), in which metal interconnections (122) and insulators are repeatedly stacked;
a semiconductor chip (14) on the PCB (12); and
a connector portion (15) extending from one side of a lower portion of the PCB (12);
a guide frame (20) comprising:
an upper frame (22) contacting an upper portion of the PCB (12);
a side frame (24, 26) comprising a sliding rail (245, 265) into which a side portion of the PCB (12) is inserted and slidably fastened; and
a lower frame (28) connected to the side frame (24, 26) opposite the upper frame (22), wherein the lower frame (28) defines a connector passage to accommodate the connector portion (15);
a telescopic rail portion (60) movably coupling the upper frame (22) and the side frame (24, 26); and
a hinge joint portion (40) comprising a hinge portion (42) connecting the side frame (24, 26) and a first side of the lower frame (28) and a joint portion (44, 46) fixing the side frame (24, 26) and a second side of the lower frame (28),
wherein the connector portion (15) is exposed through the connector passage while the side frame (24, 26) and the lower frame (28) are fixed by the hinge joint portion (40).

8. The solid state drive tray (1) of claim 7, wherein the telescopic rail portion (60) comprises:
a slide slot (64) formed in the side frame (24, 26);
an elastic member (65, 650) provided within the slide slot (64); and
a guide rod portion (62) extending from both sides of the upper frame (22) to the slide slot (64) and configured to be drawn out within the slide slot (64) by the elastic member (65, 650).

9. The solid state drive tray (1) of claim 7, wherein the telescopic rail portion (60) further comprises:
a slide channel (640) formed within the side frame (24, 26) and facing the upper frame (22);
an elastic member (65, 650) provided within the slide channel (640); and
a guide rod portion (62) extending from both sides of the upper frame (22) to the slide channel (640) and configured to be drawn out from the slide channel (640) by the elastic member (65, 650).

10. The solid state drive tray (1) of any one of claims 7 to 9, further comprising thermal grease (50),
wherein a metal interconnection (122) is exposed from the side portion of the PCB (12) inserted into the sliding rail (245, 265) of the side frame (24, 26), and the thermal grease (50) is provided between the metal interconnection (122) and the sliding rail (245, 265).

11. The solid state drive tray (1) of claim 10, further comprising a dummy solder ball (144) in the semiconductor chip (14), and in contact with the metal interconnection (122) of the PCB (12).

12. The solid state drive tray (1) of any one of claims 7 to 9, further comprising solder,
wherein a metal interconnection (122) is exposed from the side portion of the PCB (12) inserted into the sliding rail (245, 265) of the side frame (24, 26), and the solder is provided on the metal interconnection (122) exposed on the side portion.

13. The solid state drive tray (1) of claim 12, further comprising a dummy solder ball (144) in the semiconductor chip (14), and in contact with the metal interconnection (122) of the PCB (12).

14. A drive server device (100) comprising:
a plurality of solid state drive trays (1) according to any one of claims 1 to 13; and
a server body (120) configured to accommodate the plurality of solid state drive trays (1).

## Patentansprüche

1. Träger für ein Solid-State-Laufwerk (1), umfassend:
ein Solid-State-Laufwerkssubstrat (10), umfassend eine Leiterplatte, PCB (12), und einen auf der PCB (12) montierten Halbleiterchip (14);
einen Führungsrahmen (20), umfassend einen oberen Rahmen (22), der einen oberen Bereich der PCB (12) kontaktiert, einen Seitenrahmen (24, 26), der mit einer Gleitschiene (245, 265) versehen ist, in die ein Seitenbereich der PCB (12) eingesetzt und verschiebbar befestigt ist, und einen unteren Rahmen (28), der einen Steckverbinder-Durchgangsabschnitt (282) definiert;
einen Scharnierverbindungsabschnitt (40), umfassend einen Scharnierabschnitt (42), der den Seitenrahmen (24, 26) und eine Seite des unteren Rahmens (28) verbindet, und einen Verbindungsabschnitt (44, 46), der den Seitenrahmen (24, 26) und den unteren Rahmen (28) an der anderen Seite derjenigen Seite befestigt, an der der Scharnierabschnitt (42) angeordnet ist; und
einen Steckverbinderabschnitt (15), der sich von einer Seite der PCB (12) erstreckt und durch den Steckverbinder-Durchgangsabschnitt (282) nach außen freiliegt, während der Seitenrahmen (24, 26) und der untere Rahmen (28) durch den Scharnierverbindungsabschnitt (40) befestigt sind.

2. Träger für ein Solid-State-Laufwerk (1) nach Anspruch 1, wobei der obere Rahmen (22) dazu eingerichtet ist, aus dem Seitenrahmen (24, 26) herausgezogen zu werden, und
wobei der Träger für ein Solid-State-Laufwerk (1) ferner umfasst:
einen in dem Seitenrahmen (24, 26) ausgebildeten Schiebeschlitz (64);
ein elastisches Element (65, 650) in dem Schiebeschlitz (64); und
einen Führungsstangenabschnitt (62), der sich von beiden Seiten des oberen Rahmens (22) bis zu dem Schiebeschlitz (64) erstreckt und mit dem elastischen Element (65, 650) verbunden ist.

3. Träger für ein Solid-State-Laufwerk (1) nach Anspruch 1, wobei der obere Rahmen (22) dazu eingerichtet ist, aus dem Seitenrahmen (24, 26) herausgezogen zu werden, und
wobei der Träger für ein Solid-State-Laufwerk (1) ferner umfasst:
einen innerhalb des Seitenrahmens (24, 26) ausgebildeten Gleitkanal (640), der mit dem oberen Rahmen (22) verbunden ist;
ein elastisches Element (65, 650) in dem Gleitkanal (640); und
einen Führungsstangenabschnitt (62), der sich von beiden Seiten des oberen Rahmens (22) bis zu dem Gleitkanal (640) erstreckt und mit dem elastischen Element (65, 650) verbunden ist.

4. Träger für ein Solid-State-Laufwerk (1) nach Anspruch 3, ferner umfassend einen Positionsbestimmungsabschnitt (662, 664), der dazu eingerichtet ist, eine Position des Führungsstangenabschnitts (62) zu sichern, wobei der Positionsbestimmungsabschnitt (662, 664) in dem Gleitkanal (640) vorgesehen ist.

5. Träger für ein Solid-State-Laufwerk (1) nach einem der Ansprüche 1 bis 4, ferner umfassend Wärmeleitpaste (50),
wobei eine Metallverbindung (122) von dem Seitenbereich der PCB (12), der in die Gleitschiene (245, 265) des Seitenrahmens (24, 26) eingesetzt ist, freiliegt und die Wärmeleitpaste (50) zwischen der Metallverbindung (122) und der Gleitschiene (245, 265) vorgesehen ist.

6. Träger für ein Solid-State-Laufwerk (1) nach einem der Ansprüche 1 bis 5, ferner umfassend Lötmittel,
wobei eine Metallverbindung (122) von dem Seitenbereich der PCB (12), der in die Gleitschiene (245, 265) des Seitenrahmens (24, 26) eingesetzt ist, freiliegt und das Lötmittel zwischen der Metallverbindung (122) und der Gleitschiene (245, 265) vorgesehen ist.

7. Träger für ein Solid-State-Laufwerk (1), umfassend:
ein Solid-State-Laufwerkssubstrat (10), umfassend:
eine Leiterplatte, PCB (12), in der Metallverbindungen (122) und Isolatoren wiederholt gestapelt sind;
einen Halbleiterchip (14) auf der PCB (12); und
einen Steckverbinderabschnitt (15), der sich von einer Seite eines unteren Bereichs der PCB (12) erstreckt;
einen Führungsrahmen (20), umfassend:
einen oberen Rahmen (22), der einen oberen Bereich der PCB (12) kontaktiert;
einen Seitenrahmen (24, 26), der eine Gleitschiene (245, 265) umfasst, in die ein Seitenbereich der PCB (12) eingesetzt und verschiebbar befestigt ist; und
einen unteren Rahmen (28), der mit dem Seitenrahmen (24, 26) dem oberen Rahmen (22) gegenüberliegend verbunden ist, wobei der untere Rahmen (28) einen Steckverbinder-Durchgang definiert, um den Steckverbinderabschnitt (15) aufzunehmen;
einen Teleskopschienenabschnitt (60), der den oberen Rahmen (22) und den Seitenrahmen (24, 26) beweglich koppelt; und
einen Scharnierverbindungsabschnitt (40), umfassend einen Scharnierabschnitt (42), der den Seitenrahmen (24, 26) und eine erste Seite des unteren Rahmens (28) verbindet, und einen Verbindungsabschnitt (44, 46), der den Seitenrahmen (24, 26) und eine zweite Seite des unteren Rahmens (28) befestigt,
wobei der Steckverbinderabschnitt (15) durch den Steckverbinder-Durchgang freiliegt, während der Seitenrahmen (24, 26) und der untere Rahmen (28) durch den Scharnierverbindungsabschnitt (40) befestigt sind.

8. Träger für ein Solid-State-Laufwerk (1) nach Anspruch 7, wobei der Teleskopschienenabschnitt (60) umfasst:
einen in dem Seitenrahmen (24, 26) ausgebildeten Schiebeschlitz (64);
ein innerhalb des Schiebeschlitzes (64) vorgesehenes elastisches Element (65, 650);
und
einen Führungsstangenabschnitt (62), der sich von beiden Seiten des oberen Rahmens (22) bis zu dem Schiebeschlitz (64) erstreckt und dazu eingerichtet ist, durch das elastische Element (65, 650) innerhalb des Schiebeschlitzes (64) herausgezogen zu werden.

9. Träger für ein Solid-State-Laufwerk (1) nach Anspruch 7, wobei der Teleskopschienenabschnitt (60) ferner umfasst:
einen innerhalb des Seitenrahmens (24, 26) ausgebildeten Gleitkanal (640), der dem oberen Rahmen (22) zugewandt ist;
ein innerhalb des Gleitkanals (640) vorgesehenes elastisches Element (65, 650); und
einen Führungsstangenabschnitt (62), der sich von beiden Seiten des oberen Rahmens (22) bis zu dem Gleitkanal (640) erstreckt und dazu eingerichtet ist, durch das elastische Element (65, 650) aus dem Gleitkanal (640) herausgezogen zu werden.

10. Träger für ein Solid-State-Laufwerk (1) nach einem der Ansprüche 7 bis 9, ferner umfassend Wärmeleitpaste (50),
wobei eine Metallverbindung (122) von dem Seitenbereich der PCB (12), der in die Gleitschiene (245, 265) des Seitenrahmens (24, 26) eingesetzt ist, freiliegt und die Wärmeleitpaste (50) zwischen der Metallverbindung (122) und der Gleitschiene (245, 265) vorgesehen ist.

11. Träger für ein Solid-State-Laufwerk (1) nach Anspruch 10, ferner umfassend eine Dummy-Lötkugel (144) in dem Halbleiterchip (14) und in Kontakt mit der Metallverbindung (122) der PCB (12).

12. Träger für ein Solid-State-Laufwerk (1) nach einem der Ansprüche 7 bis 9, ferner umfassend Lötmittel,
wobei eine Metallverbindung (122) von dem Seitenbereich der PCB (12), der in die Gleitschiene (245, 265) des Seitenrahmens (24, 26) eingesetzt ist, freiliegt und das Lötmittel auf der an dem Seitenbereich freiliegenden Metallverbindung (122) vorgesehen ist.

13. Träger für ein Solid-State-Laufwerk (1) nach Anspruch 12, ferner umfassend eine Dummy-Lötkugel (144) in dem Halbleiterchip (14) und in Kontakt mit der Metallverbindung (122) der PCB (12).

14. Laufwerk-Servervorrichtung (100), umfassend:
eine Vielzahl von Trägern für Solid-State-Laufwerke (1) gemäß einem der Ansprüche 1 bis 13; und
einen Serverkörper (120), der dazu eingerichtet ist, die Vielzahl von Trägern für Solid-State-Laufwerke (1) aufzunehmen.

## Revendications

1. Support pour lecteur à état solide (1) comprenant :
un substrat de lecteur à état solide (10) comprenant une carte de circuit imprimé, PCB (12), et une puce semi-conductrice (14) montée sur la PCB (12) ;
un cadre de guidage (20) comprenant un cadre supérieur (22) en contact avec une partie supérieure de la PCB (12), un cadre latéral (24, 26) pourvu d'un rail coulissant (245, 265) dans lequel une partie latérale de la PCB (12) est insérée et fixée de manière coulissante, et un cadre inférieur (28) définissant une partie de passage de connecteur (282) ;
une partie de liaison à charnière (40) comprenant une partie charnière (42) reliant le cadre latéral (24, 26) et un côté du cadre inférieur (28), et une partie de jonction (44, 46) fixant le cadre latéral (24, 26) et le cadre inférieur (28) à l'autre côté de l'un des côtés sur lequel est disposée la partie charnière (42) ; et
une partie connecteur (15) s'étendant depuis un côté de la PCB (12) et exposée extérieurement par l'intermédiaire de la partie de passage de connecteur (282) tandis que le cadre latéral (24, 26) et le cadre inférieur (28) sont fixés par la partie de liaison à charnière (40).

2. Support pour lecteur à état solide (1) selon la revendication 1, dans lequel le cadre supérieur (22) est configuré pour être tiré vers l'extérieur hors du cadre latéral (24, 26), et
dans lequel le support pour lecteur à état solide (1) comprend en outre :
une fente de coulissement (64) formée dans le cadre latéral (24, 26) ;
un élément élastique (65, 650) dans la fente de coulissement (64) ; et
une partie de tige de guidage (62) s'étendant depuis les deux côtés du cadre supérieur (22) jusqu'à la fente de coulissement (64) et reliée à l'élément élastique (65, 650).

3. Support pour lecteur à état solide (1) selon la revendication 1, dans lequel le cadre supérieur (22) est configuré pour être tiré vers l'extérieur hors du cadre latéral (24, 26), et
dans lequel le support pour lecteur à état solide (1) comprend en outre :
un canal de coulissement (640) formé dans le cadre latéral (24, 26) et relié au cadre supérieur (22) ;
un élément élastique (65, 650) dans le canal de coulissement (640) ; et
une partie de tige de guidage (62) s'étendant depuis les deux côtés du cadre supérieur (22) jusqu'au canal de coulissement (640) et reliée à l'élément élastique (65, 650).

4. Support pour lecteur à état solide (1) selon la revendication 3, comprenant en outre une partie de détermination de position (662, 664) configurée pour fixer une position de la partie de tige de guidage (62), dans lequel la partie de détermination de position (662, 664) est prévue dans le canal de coulissement (640).

5. Support pour lecteur à état solide (1) selon l'une quelconque des revendications 1 à 4, comprenant en outre une pâte thermique (50),
dans lequel une interconnexion métallique (122) est exposée au niveau de la partie latérale de la PCB (12) insérée dans le rail coulissant (245, 265) du cadre latéral (24, 26), et la pâte thermique (50) est prévue entre l'interconnexion métallique (122) et le rail coulissant (245, 265).

6. Support pour lecteur à état solide (1) selon l'une quelconque des revendications 1 à 5, comprenant en outre un matériau de soudure,
dans lequel une interconnexion métallique (122) est exposée au niveau de la partie latérale de la PCB (12) insérée dans le rail coulissant (245, 265) du cadre latéral (24, 26), et le matériau de soudure est prévue entre l'interconnexion métallique (122) et le rail coulissant (245, 265).

7. Support pour lecteur à état solide (1) comprenant :
un substrat de lecteur à état solide (10) comprenant :
une carte de circuit imprimé, PCB (12), dans laquelle des interconnexions métalliques (122) et des isolants sont empilés de manière répétée ;
une puce semi-conductrice (14) sur la PCB (12) ; et
une partie connecteur (15) s'étendant depuis un côté d'une partie inférieure de la PCB (12) ;
un cadre de guidage (20) comprenant :
un cadre supérieur (22) en contact avec une partie supérieure de la PCB (12) ;
un cadre latéral (24, 26) comprenant un rail coulissant (245, 265) dans lequel une partie latérale de la PCB (12) est insérée et fixée de manière coulissante ; et
un cadre inférieur (28) relié au cadre latéral (24, 26) à l'opposé du cadre supérieur (22), dans lequel le cadre inférieur (28) définit un passage de connecteur destiné à recevoir la partie connecteur (15) ;
une partie de rail télescopique (60) couplant de manière mobile le cadre supérieur (22) et le cadre latéral (24, 26) ; et
une partie de liaison à charnière (40) comprenant une partie charnière (42) reliant le cadre latéral (24, 26) et un premier côté du cadre inférieur (28), et une partie de jonction (44, 46) fixant le cadre latéral (24, 26) et un deuxième côté du cadre inférieur (28),
dans lequel la partie connecteur (15) est exposée par l'intermédiaire du passage de connecteur tandis que le cadre latéral (24, 26) et le cadre inférieur (28) sont fixés par la partie de liaison à charnière (40).

8. Support pour lecteur à état solide (1) selon la revendication 7, dans lequel la partie de rail télescopique (60) comprend :
une fente de coulissement (64) formée dans le cadre latéral (24, 26) ;
un élément élastique (65, 650) prévu à l'intérieur de la fente de coulissement (64) ; et
une partie de tige de guidage (62) s'étendant depuis les deux côtés du cadre supérieur (22) jusqu'à la fente de coulissement (64) et configurée pour être tirée vers l'extérieur dans la fente de coulissement (64) par l'élément élastique (65, 650).

9. Support pour lecteur à état solide (1) selon la revendication 7, dans lequel la partie de rail télescopique (60) comprend en outre :
un canal de coulissement (640) formé dans le cadre latéral (24, 26) et faisant face au cadre supérieur (22) ;
un élément élastique (65, 650) prévu à l'intérieur du canal de coulissement (640) ; et
une partie de tige de guidage (62) s'étendant depuis les deux côtés du cadre supérieur (22) jusqu'au canal de coulissement (640) et configurée pour être tirée vers l'extérieur hors du canal de coulissement (640) par l'élément élastique (65, 650).

10. Support pour lecteur à état solide (1) selon l'une quelconque des revendications 7 à 9, comprenant en outre une pâte thermique (50),
dans lequel une interconnexion métallique (122) est exposée au niveau de la partie latérale de la PCB (12) insérée dans le rail coulissant (245, 265) du cadre latéral (24, 26), et la pâte thermique (50) est prévue entre l'interconnexion métallique (122) et le rail coulissant (245, 265).

11. Support pour lecteur à état solide (1) selon la revendication 10, comprenant en outre une bille de soudure factice (144) dans la puce semi-conductrice (14), et en contact avec l'interconnexion métallique (122) de la PCB (12).

12. Support pour lecteur à état solide (1) selon l'une quelconque des revendications 7 à 9, comprenant en outre un matériau de soudure,
dans lequel une interconnexion métallique (122) est exposée au niveau de la partie latérale de la PCB (12) insérée dans le rail coulissant (245, 265) du cadre latéral (24, 26), et le matériau de soudure est prévue sur l'interconnexion métallique (122) exposée sur la partie latérale.

13. Support pour lecteur à état solide (1) selon la revendication 12, comprenant en outre une bille de soudure factice (144) dans la puce semi-conductrice (14), et en contact avec l'interconnexion métallique (122) de la PCB (12).

14. Dispositif serveur de lecteurs (100) comprenant :
une pluralité de supports pour lecteurs à état solide (1) selon l'une quelconque des revendications 1 à 13 ; et
un corps de serveur (120) configuré pour recevoir la pluralité de supports pour lecteurs à état solide (1).
